Europäisches Patentamt

European Patent Office

Office européen des brevets

(11) Publication number: **0 273 743**
**A2**

# EUROPEAN PATENT APPLICATION

(21) Application number: **87311454.0**

(22) Date of filing: **24.12.87**

(51) Int. Cl.⁴: **H 01 L 27/10**
**G 09 F 9/35, H 01 L 21/28**

(30) Priority: **26.12.86 JP 315341/86**

(43) Date of publication of application:
**06.07.88 Bulletin 88/27**

(84) Designated Contracting States: **DE FR GB**

(71) Applicant: **KABUSHIKI KAISHA TOSHIBA**
**72, Horikawa-cho Saiwai-ku**
**Kawasaki-shi Kanagawa-ken 210 (JP)**

(72) Inventor: **Ikeda, Mitsushi c/o Patent Division**
**Kabushiki Kaisha Toshiba 1-1 Shibaura 1-chome**
**Minato-ku Tokyo 105 (JP)**

**Oana, Yasuhisa c/o Patent Division**
**Kabushiki Kaisha Toshiba 1-1 Shibaura 1-chome**
**Minato-ku Tokyo 105 (JP)**

**Dohjo, Masayuki c/o Patent Division**
**Kabushiki Kaisha Toshiba 1-1 Shibaura 1-chome**
**Minato-ku Tokyo 105 (JP)**

(74) Representative: **Freed, Arthur Woolf et al**
**MARKS & CLERK 57-60 Lincoln's Inn Fields**
**London WC2A 3LS (GB)**

(54) Electronic device having electrode and driving circuit substrate for display device.

(57) This invention provides an electronic device using an oxide film of a molybdenum-tantalum alloy having a tantalum composition ratio of 50 to 97 atomic percent. According to this invention, the oxide film of the Mo-Ta alloy is higher in resistivity than the oxide film of Ta. Therefore, the TFT and MIM elements using the oxide film of the Mo-Ta alloy have a small leak electric current because of the high resistivity of the oxide film. And an anodic oxidation film of the Mo-Ta alloy of a better quality can be formed for a multi-layered insulating film.

F I G. 6A

**0 273 743**

**Description**

Electronic device having electrode and driving circuit substrate for display device

The present invention relates to an electronic device having an electrode and to a driving circuit substrate for display device.

In recent times, an active matrix type liquid crystal display device having a switching element at each picture elements is utilized for a liquid crystal display device. As a switching element, the nonlinear elements of TFT (Thin-Film-Transistor), MIM (Metal-Insulator-Metal structure) and the like are utilized for increasing the effective duty ratio of the voltage applied to each picture element. As an insulating film for these thin film electron devices, a tantalum oxide film ($TaO_x$) and multi-layered structure of a tantalum oxide film and silicon oxide film ($TaO_x/SiO_x$) are known (Proceedings of "Eurodisplay '81", pp. 220 ~ 223). However, the TFT and MIM elements using the tantalum oxide film have a large leak electric current because of the small resistivity of the tantalum oxide film. And for the TFT using the tantalum oxide film, the driving voltage can not be increased sufficiently due to the small breakdown electric field of the tantalum oxide film, and therefore the ON current available for the TFT is limited.

An object of the present invention is to provide an electronic device using a high resistivity oxide film of an alloy as an insulating film. Another object of the present invention is to provide a driving circuit substrate for a display device using a high resistivity oxide film of the alloy as an insulating film.

Briefly described, this object of the present invention is accomplished by the electronic device and the driving circuit substrate for a display device using an oxide film of a molybdenum-tantalum alloy having a tantalum composition ratio of 50 to 97 atomic percent.

This invention can be more fully understood from the following detailed description when taken in conjunction with the accompanying drawings, in which:

Fig. 1 shows a comparison in resistivity between an electrode material of Mo-Ta alloy for a multi-layered structure and a single-layered structure;

Fig. 2 shows a comparison in insulation break-down electric field between the Mo-Ta alloy oxide film and a Ta oxide film;

Fig. 3 shows a comparison in resistivity between the Mo-Ta alloy oxide film and a Ta oxide film;

Fig. 4 is an equivalent circuit diagram showing an active matrix type liquid crystal display device according to one embodiment of this invention;

Fig. 5 is an enlarged plan view showing a major portion of an active matrix substrate in Fig. 4;

Fig. 6A to 6B are cross-sectional views, as taken along lines A-A' and B-B' respectively in Fig. 5;

Fig. 7 shows a comparison in characteristic of the relationship between a gate electric field VG and a drain electric current $I_D$ between the TFT of the invention and the TFT using Ta oxide film;

Fig. 8 is a cross-sectional view of the MIM element of this invention;

Fig. 9 shows a characteristic of the relationship between an impressed voltage V and a leak electric current I of MIM; and

Fig. 10 is a cross-sectional view, as taken along line A-A' in Fig. 5, with an underlying metal film used.

According to this invention an electronic device and a driving circuit substrate for a display device are provided which are characterized by using an oxide film of an Mo-Ta alloy with a Ta composition range of 50 to 97 atomic percent as an insulating material.

And also, according to this invention, an oxide film of an Mo-Ta alloy is employed as an insulating material of a TFT with the use of an a-Si (amorphous Si) film or as its drain and source electrodes and as a gate electrode interconnection material over a single crystalline silicon substrate, noting that the Ta composition ratio is 50 to 97 atomic percent. A total amount of the Mo and Ta may be within a range of above 95 atomic percent in which case the other materials may be contained in a range of less than 5 atomic percent, such as carbon, oxygen, argon, hydrogen and nitrogen. The Mo-Ta alloy is smaller in resistivity than those metals such as Ta, Ti and even smaller than $MoSi_2$. In application Serial No. 86309698.8, filed December 12, 1986 (M. Dohjo, Y. Oana, M. Ikeda), there is described and claimed a semiconductor device using a molybdenum-tantalum alloy having a tantalum composition ratio of 30 to 84 atomic percent. The Mo-Ta alloy has also a workability, better resistance to various chemicals and excellent ohmic contact with a semiconductor, such as silicon.

Before explaining an embodiment of this invention as applied to a practical device, comparison will be made in various characteristics between an Mo-Ta alloy film and other electrode interconnection film materials. In this connection reference should be invited to the following Table, noting that in relation to the contents of Mo and Ta in Table their decimal point et seq. are cancelled.

Table

| | | Example | | | | | | | | | | | |
|---|---|---|---|---|---|---|---|---|---|---|---|---|---|
| | Mo (at%) | 90 | 80 | 75 | 70 | 60 | 50 | 40 | 30 | 20 | 16 | 5 | 2 |
| | Ta (at%) | 10 | 20 | 25 | 30 | 40 | 50 | 60 | 70 | 80 | 84 | 95 | 98 |
| resistivity ($\times 10^{-5}$ $\Omega \cdot cm$) | after deposition | 5.2 | 5.1 | 4.9 | 4.3 | 3.4 | 3.8 | 4.5 | 4.0 | 3.4 | 3.4 | 18.2 | 18.4 |
| | after heat-treatment at 300°C | 5.0 | 4.9 | 4.7 | 4.0 | 3.2 | 3.5 | 4.1 | 3.6 | 3.2 | 3.2 | 17.1 | 17.3 |
| | after heat-treatment at 1000°C | 4.4 | 4.3 | 4.0 | 1.6 | 1.4 | 1.5 | 2.0 | 1.7 | 1.6 | 1.6 | 9.2 | 9.4 |
| workability (dry) | | o | o | o | o | o | o | o | o | o | o | o | o |
| taper formation | | o | o | o | o | o | o | o | o | o | o | o | o |
| thermally oxidized film formation | | × | × | Δ | o | o | o | o | o | o | o | o | o |
| anodized film formation | | × | × | Δ | o | o | o | o | o | o | o | o | o |
| washing with ($H_2SO_4 + H_2O_2$) solution | | × | × | × | o | o | o | o | o | o | o | o | o |
| ohmic contact with silicon | | o | o | o | o | o | o | o | o | o | o | o | o |
| no reactivity with $SiO_2$ film | | o | o | o | o | o | o | o | o | o | o | o | o |

0 273 743

| | | Control | | | | |
|---|---|---|---|---|---|---|
| | | Ti | Cr | Mo | β-Ta | MoSi$_2$ |
| resistivity ($\times$ 10$^{-5}$ $\Omega \cdot$ cm) | after deposition | 47 | 13 | 5.3 | 26 | 91 |
| | after heat-treatment at 300°C | 46 | 13 | 5.0 | 22 | 99 |
| | after heat-treatment at 1000°C | 45 | 13 | 4.5 | 20 | 75 |
| workability (dry) | | Δ | Δ | o | o | o |
| taper formation | | Δ | × | o | o | o |
| thermally oxidized film formation | | × | × | × | o | o |
| anodized film formation | | × | × | × | o | o |
| washing with (H$_2$SO$_4$ + H$_2$O$_2$.) solution | | × | o | × | o | o |
| ohmic contact with silicon | | × | × | o | o | o |
| no reactivity with SiO$_2$ film | | Δ | Δ | ˙Δ | o | o |

Evaluation was made, by a rating of o (better), Δ (somewhat better) and × (poor) (same hereafter), for the dry etchability of a CF$_4$ system and for taper angle controllability by the dry etching of the CF$_4$ system. For a thermally oxidized film formation, evaluation was made as to whether or not an oxide film free from any pinholes was obtained at a temperature of about 400°C with a breakdown electric field of above 3 × 10$^6$ V/cm and leakage current density of 1 × 10$^{-8}$ A/cm$^2$. For the formation of an anodized film, evaluation was made as to whether or not a pinholeless oxide film was obtained at a temperature of above 400°C with a breakdown electric field of above 3 × 10$^6$ V/cm and leakage current density of below 1 × 10$^{-8}$ A/cm$^2$. For an ohmic contact with silicon, evaluation was made as to whether or not an interface is formed by a complete MoSi$_2$ of a better ohmic contact and, for a no-reactivity with the oxide film, evaluation was made as to whether or not a reaction occurred at a temperature of about 400°C.

Respective electrode interconnection films are formed at room temperature by virtue of a sputtering method. As evident from Table an Mo-Ta alloy film, after deposited at room temperature, reveals a smaller resistivity than those of Ti, Cr, β-Ta and MoSi$_2$ films and, for less than 84 atomic percent of Ta in particular, than an Mo film. The alloy film, when heat-treated after that deposition step, manifests a still lower resistivity. Furthermore, the alloy film also shows an excellent dry-etching workability as in the case of an MoSi$_2$ film and allows a ready formation of a taper. No better thermally oxidized film is obtained for the Mo, Ti and Cr film. The Mo-Ta alloy film having a Ta composition ratio of more than 30 atomic percent shows an excellent thermal oxidation and, in addition, an excellent resistance to a mixture solution of H$_2$SO$_4$ and H$_2$O$_2$ which has extensively been used as a washing liquid. It has further been found that the alloy film has a better compatibility with an Si-used semiconductor device due to its excellent ohmic contact with Si and its low reactivity with an SiO$_2$.

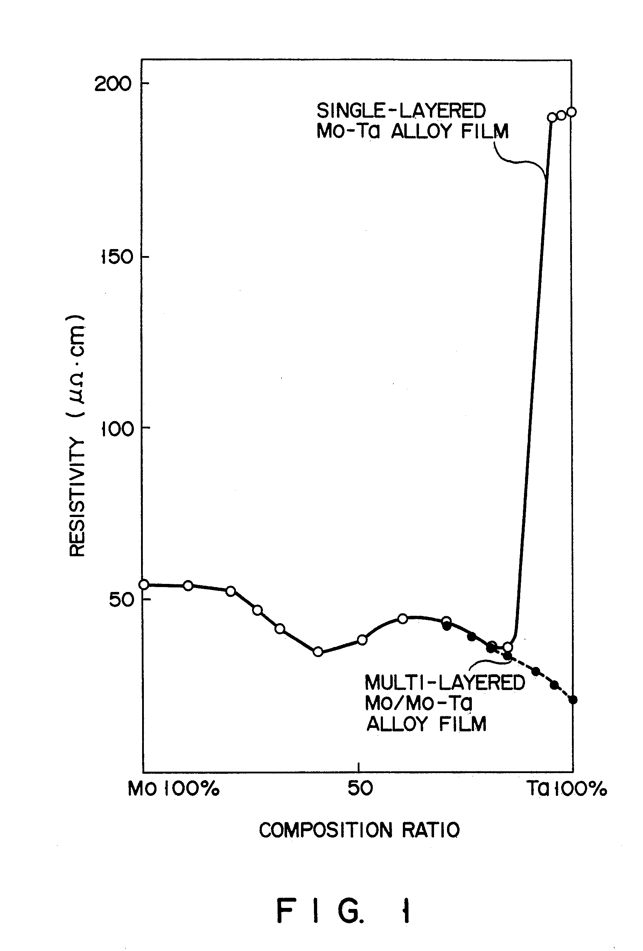

Fig. 1 shows a comparison in resistivity between an Mo-Ta alloy film formed as a single-layered film on a glass substrate by a sputtering method and a multi-layered film with an Mo-Ta alloy film formed on an underlying Mo film. When the composition ratio of Ta exceeds 84 atomic percent for the single-layered film, the resistivity increases abruptly. Even when the composition ratio of Ta is increased (to more than 84 atomic percent) for a multi-layered film, the resistivity is not increased. This is a marked difference upon comparison with the single-layered film.

The film may be formed by the sputtering method, as well as by, for example, an electron beam evaporation method. Since the underlying metal film primarily determines the crystal structure of the overlying Mo-Ta alloy film, it is only necessary for the underlying metal film to have a thickness of nearly above 100 Å. As the body-centered cubic lattice type metal, use may be made of V, Cr, Fe, Nb, Mo and W whose lattice constant is similar to that of Mo and Ta, as well as an Mo-Ta alloy whose Ta composition ratio is within a range of 0 to 84 atomic percent.

Next, the oxide film of the Mo-Ta alloy will now be described below. In this experiment, Mo-Ta alloy films with various Ta and Mo composition ratios are formed on glass substrate.

An anodized film is formed on the surface of the Mo-Ta alloy films, noting that the anodic oxidation was conducted in 0.01 wt% citric acid solution at a temperature ranging from room temperature to 70°C. And the anodic oxidation was conducted at a current density of 0.5 mA/cm$^2$ up to 100 V as a constant-current oxidation. Then the anodic oxidation is continued at 100 V for one hour as a constant-voltage oxidation.

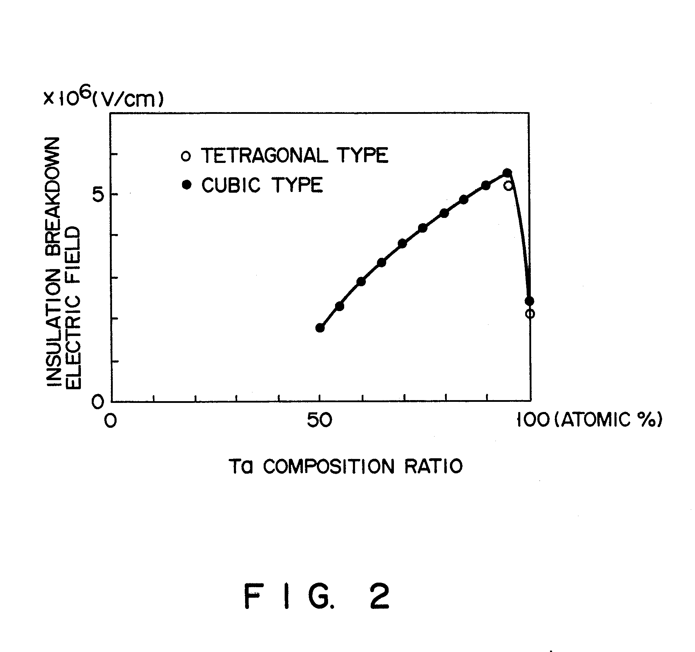

Fig. 2 shows the connection reference of the insulation breakdown electric field of the resultant Mo-Ta alloy oxidation films.

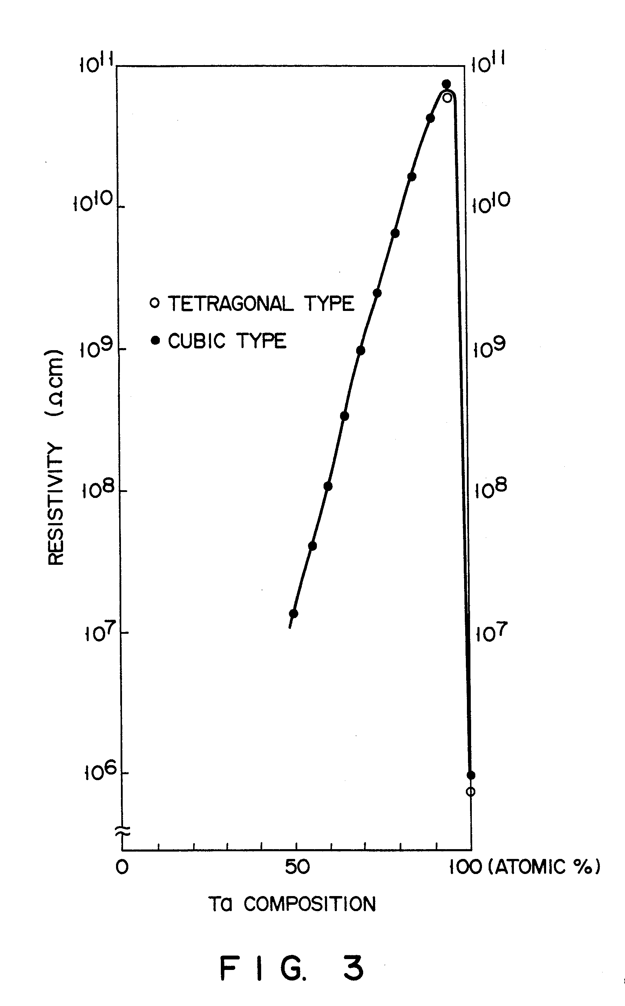

Fig. 3 shows the resistivity of the resultant Mo-Ta alloy oxidation films measured with a bias of 30 V. As evident from Fig. 2 and Fig. 3, the Mo-Ta alloy oxidized film reveals a high insulation breakdown electric field and a high resistivity. The dielectric constant of the Mo-Ta alloy oxidation film of this invention is about 30 at the frequency range from 10 kHz to 1 MHz.

As a result of the experiment of the resistance of the Mo-Ta alloy oxidation film to various chemicals, it was confirmed that the Mo-Ta alloy oxidation film was not eroded by acid of HF, $NH_4F$, $HNO_3$, $H_2SO_4$, $HC\ell$, $H_2O_2$ and so on. And, as a workability, it was confirmed that the Mo-Ta alloy oxidation film was easily etched by a plasma etching in $CF_4$ and $O_2$ gas. Furthermore, the taper etching of the Mo-Ta alloy oxidation film was conducted by the controlling the mixture ratio of the gases. The Mo-Ta alloy whose tantalum composition is more than 84 atomic percent has two kinds of crystalline structures, a tetragonal type and cubic type. However, the characteristics of oxidized film of Mo-Ta alloy with those two kinds of crystalline structures make no difference.

A practical form of a device using the invention will be explained below.

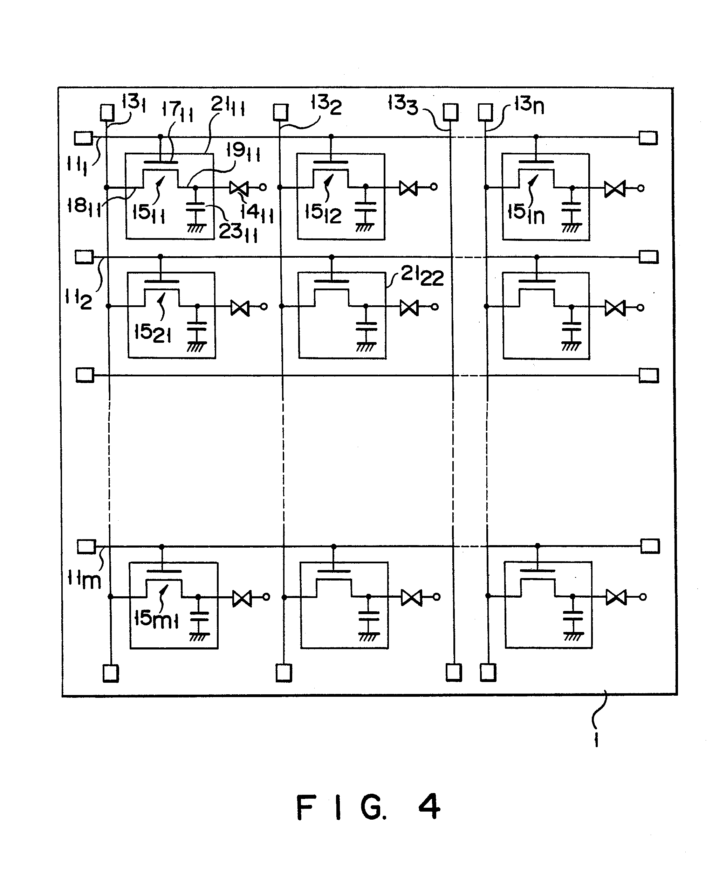

Fig. 4 is an equivalent circuit diagram showing an interconnection material of this invention as applied to an active matrix type liquid crystal display device using an inverted staggered type TFT. Address lines 11 ($11_1$, $11_2$, ..., $11_m$) and data lines 13 ($13_1$, $13_2$, ..., $13_n$) are arranged as a matrix array on glass substrate 1 with TFT 15 ($15_{11}$, ..., $15_{mn}$) placed in a corresponding intersection. TFT $15pq$ (p = 1, 2, ..., m; q = 1, 2, ..., n) has its gate electrode $17pq$ connected to address line $11p$, its source electrode $18pq$ to data line $13q$ and its drain electrode $19pq$ connected to liquid crystal cell $14pq$ via pixel electrode $21pq$. Capacitor $23pq$, though shown in Fig. 4, can be omitted. Gate electrode $17pq$ is formed, in reality, integral with address line $11p$.

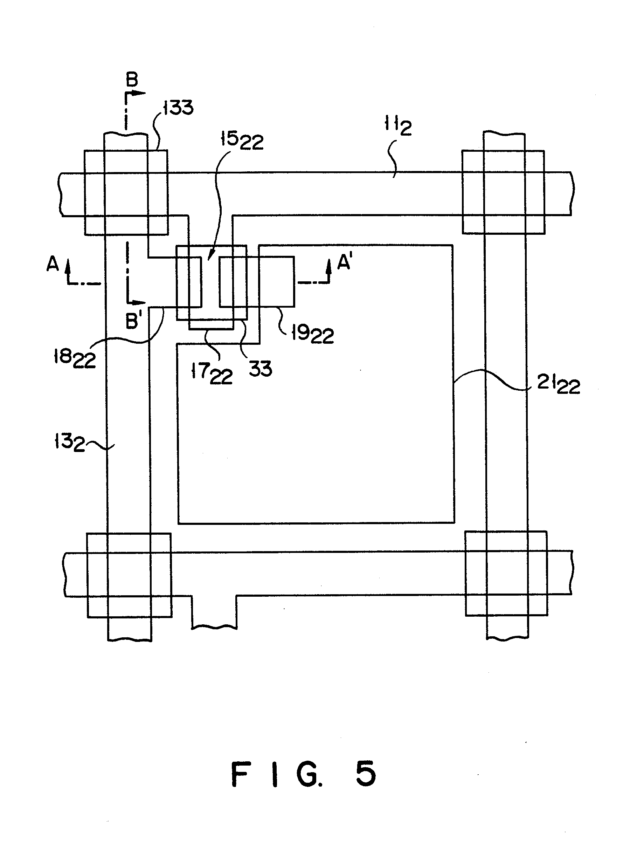

Fig. 5 is an enlarged plan view showing one pixel area ($21_{22}$) in the substrate in Fig. 4.

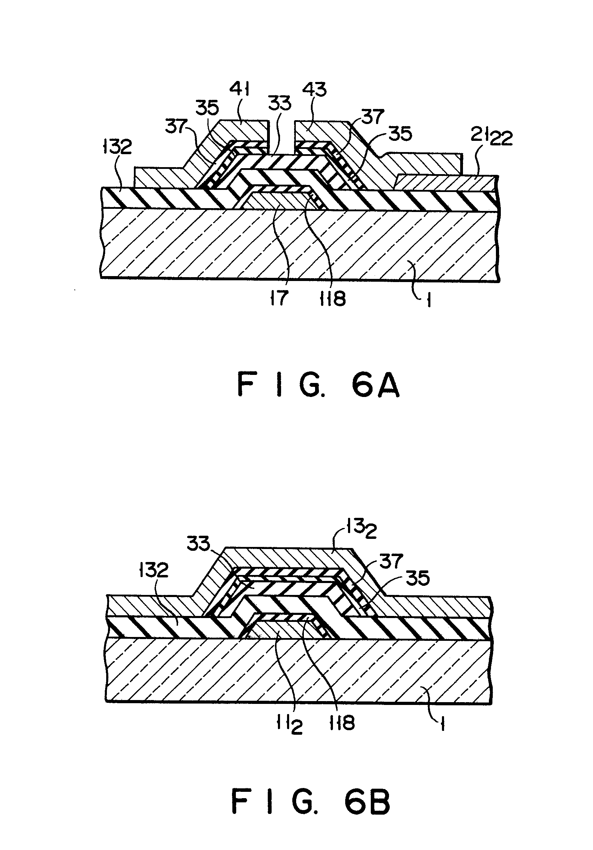

A liquid crystal display device is manufactured as follows. Reference is invited to Figs. 6A and 6B. Figs. 6A and 6B show an embodiment of this invention in which the surface of a gate electrode is anodized. Fig. 6A is a cross-sectional view as taken along line A-A' in Fig. 5 and Fig. 6B is a cross-sectional view as taken along line B-B' in Fig. 5. An Mo-Ta alloy film was deposited by sputtering on glass substrate 1 and the resultant structure was patterned by a PEP (photoengraving process) to form gate electrode 17. Gate electrode 17 was formed of the same material as that of address line 11 (See Fig. 1) and formed, by the same process, integral with the address line. In order to prevent a possible step breakage on gate electrode 17 and on the address line at that step their edges were tapered. A ready taper etching step was able to be performed using a resist and $CF_4$ + $O_2$. Gate electrode 17 of this embodiment was 200 nm thick and 30 μm wide, noting that the gate electrode has a thickness the same as that of the address line. After gate electrode 17 was formed, 61 nm-thick oxidation film 118 was formed on the gate electrode 17 by an anodic oxidation. Anodized film 118 was formed on the surface of the resultant structure, noting that the anodic oxidation was conducted in 0.01 wt% citric acid solution at a temperature ranging from room temperature to 70°C.

The anodized film had a breakdown electric field of above $5.0 \times 10^6$ V/cm and specific dielectric constant of 30. Then 200 nm-thick $SiO_2$ film 132 was formed by a plasma enhanced CVD on the whole surface of the resultant structure. Then 300 nm-thick undoped a-Si film 33, 50 nm-thick n+ type a-Si film 35 and 50 nm-thick Mo film 37 were formed in that order. These three layers were left by etching at the thin-film transistor section and at the respective intersection of address line 11 and data line 13 on address line 11. What is important at this step was a process before gate insulating film 132 was deposited. The gate electrode was subjected by PEP to a patterning and a larger amount of organic (the left resist, for example,) and inorganic contaminants were present in the surface of the gate electrode. A washing step was carried out by immersing the glass substrate into a mixture solution of $H_2SO_4$ and $H_2O_2$ with the gate electrode formed on the glass substrate. The gate electrode of the alloy film of this invention revealed an adequate corrosion- and etching-resistance to a washing liquid. Then, display electrode 21 for the respective pixel was formed by a 150 nm-thick ITO (indium tin oxide) film. Finally, the resultant structure was subjected to an A$\ell$-film deposition and patterning to form data line 13 and continuous source electrode 41 and drain electrode 43. Source electrode 41 was formed integral with data line 13 in Fig. 1 to contact with display electrode 21. In this case a liquid crystal layer, if sandwiched between the active matrix substrate and opposite electrode substrate, provides a liquid crystal display device.

Where subsequent to the formation of the anodized film the $SiO_2$ film is deposited to provide a gate insulating film, it is possible to effectively prevent such a defect resulting from the layer-to-layer short-circuiting. Furthermore, the second insulating film can be thinned, thus offering an advantage of lowering the threshold voltage of TFT's. Forming an anodic oxidation film on the whole, not to mention the gate electrode area, prevents defects resulting from the interlayer short-circuiting at that intersection in particular. A good-quality oxide film can be formed by thermally oxidizing the gate electrode and the other surface in an oxygen atmosphere, for example, for one hour at an atmospheric pressure and 400°C.

In the active matrix substrate of this embodiment a thin-film transistor was formed with anodized film 118 and $SiO_2$ film 132 as a gate insulating film. In the respective intersection of address line 11 and data line 13, a multi-layered film of a-Si film 33, $n^+$ type a-Si film 35 and Mo film 37 are formed on an insulating anodized film 118 and $SiO_2$ film 132 to provide an insulating interlayer.

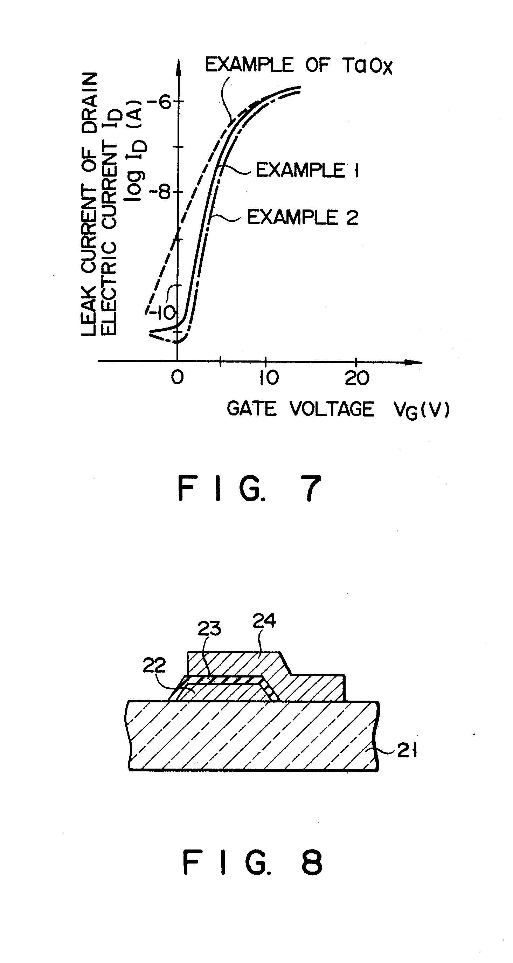

Fig. 7 shows the characteristics of the relationship between a gate electric field $V_G$ and a drain electric current $I_D$ of a TFT. In Fig. 7, a solid line shows the characteristic of the TFT using the Mo-Ta alloy film as a gate electrode and the anodized film of the Mo-Ta alloy film as a gate insulating film (Example 1). In Fig. 7, a broken line shows the characteristic of the TFT as a comparative example using a Ta film as a gate electrode and the anodized film of the Ta film as a gate insulating film.

A dot chain line shows the characteristic of the TFT using the Mo-Ta alloy film as a gate electrode and the anodized film of the Mo-Ta alloy and $SiO_2$ film as a gate insulating film (Example 2).

The leak current of the drain electric current $I_D$ is reduced about 2 figures compared to the comparative example when the gate electric field $V_G$ is OFF. When the gate electric field $V_G$ is ON, the drain electric current $I_D$ of Example 1 is increased compared to that of Example 2 by reason of the dielectric constant of the Mo-Ta alloy oxidation film of this invention is greater than that of the gate insulating film using $SiO_2$.

After the anodized film of the gate electrode is formed, $SiO_2$ film can be deposited on the anodized film, for example by the plasma CVD (Chemical Vapor Deposition).

With regard to Example 2, gate capacity and ON current are reduced due to $SiO_2$ film, but the characteristic of the TFT is good as well as Example 1.

The breakdown electric field of the gate in Example 1 and 2 is greater than 100 V.

Fig. 8 shows one embodiment of MIM element of this invention. 2500 Å-thick Mo-Ta alloy film 22 having Mo composition ratio of 5 atomic percent and Ta composition ratio of 95 atomic percent is formed on glass substrate 21, then an electrode interconnection is patterned by CDE (Chemical Dry Etching). The contact portion of the electrode interconnection is covered by a photo resist, then anodized film 23 is formed on the surface of Mo-Ta alloy film 22. The anodic oxidation was conducted in 0.01 wt% citric acid solution as a constant-current oxidation up to 25 V, then the anodic oxidation is continued at 25 V for one hour as a constant-voltage oxidation. One µm-thick Aℓ film 24 is formed on glass substrate 21 and anodic oxidized film 23, then another electrode connection is formed by patterning.

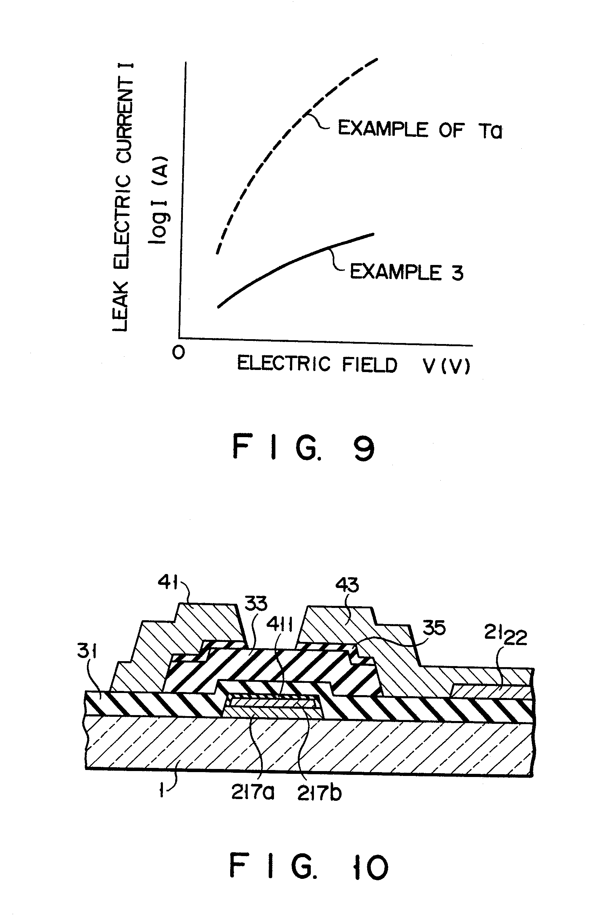

Fig. 9 shows the characteristics of the leak electric current I of an MIM shown in Fig. 8 and an MIM element using a Ta and the anodic oxidation film of the Ta. Leak electric current of this example is reduced big as compared to the anodic oxidation of the Ta.

The alloys to TFT and MIM elements in the above embodiment of this invention may apply to various electronic devices. For example, in order to reduce interconnection resistivity, the Mo-Ta alloy film is formed on a metal electrode which has less resistivity such as Cu, Au, Aℓ, and then the oxide film of the Mo-Ta alloy may be formed by an anodic oxidation or thermal oxidation.

The active matrix substrate will be described below with reference to Fig. 10. A gate electrode integral with the address line was formed, as multi-layered film of 30 nm-thick Mo-Ta alloy film (80% of Ta) 217a as an underlying metal film and 170 nm-thick Mo-Ta alloy film (95% of Ta) 217b as an overlying metal film, on glass substrate 1. Subsequent to the formation of the gate electrode, washing was carried out in the same way as in the previous embodiment.

An anodized film 411 and 150 nm-thick $SiO_2$ 31 as a gate insulating film were deposited by the CVD method on the surface of the resultant structure.

Then 300 nm-thick a-Si film (undoped) 33 and 50 nm-thick a-Si film 35 of an $n^+$ type were sequentially deposited on the surface of the resultant structure, thus forming an island pattern at the TFT area. Source electrode 41 and drain electrode 43 were formed as an Aℓ layer on the surface of the resultant structure, noting that source electrode 41 was formed integral with data line 13 as set forth above. Subsequent to the formation of the island-like a-Si film, ITO pixel electrode $21_{22}$ was formed adjacent to that a-Si film and drain electrode 43 was electrically connected to pixel electrode $21_{22}$. In this way a liquid crystal display device was fabricated which had a surface area of 19.2 cm × 25.6 cm, pixel pitch of 400 µm and address line of 30 µm in width.

In this embodiment, address line had a resistance of 12.8 KΩ. In this connection it is to be noted that an address line was formed by the other materials and it is found that the resistances of these other materials of Ti, Cr, Mo, Ta and Mo-Ta alloy (60 % of Ta) were 200.5 KΩ, 55.4 KΩ, 22.6 KΩ, 100.9 KΩ and 19.2 KΩ, respectively.

Although explanation has been made of the active matrix type liquid crystal display device using a-Si TFT's, this invention is equally applied to an a-Si diode and liquid crystal display device using an MIM (metal insulator metal) device.

This invention is not restricted to the aforementioned embodiment. For example, an Mo-Ta alloy is obtained by a co-sputtering method with the Mo target and Ta target. It is also possible to obtain a similar alloy film through a thermal decomposition by organic gases containing an Mo and Ta. This invention can be applied not only to an Si film, such as an a-Si film, polycrystalline silicon film and single crystalline Si film but also to the other semiconductor material films, such as CdSe, Te, GaAs, and GaP films.

**0 273 743**

Various modifications will become possible for those skilled in the art after receiving the teachings of the present disclosure without departing from the scope thereof.

**Claims**

1. An electronic device having a metal electrode and an oxide film overlying said metal electrode, characterized in that said oxide film is composed of oxide of a molybdenum-tantalum alloy having a tantalum composition ratio of 50 to 97 atomic percent.

2. An electronic device according to claim 1, characterized in that said oxide film is an anodic oxidized film of said molybdenum-tantalum alloy.

3. An electronic device according to claim 1, characterized in that said oxide film is a thermally oxidized film of said molybdenum-tantalum alloy.

4. An electronic device according to claim 1, characterized in that said metal electrode is a molybdenum-tantalum alloy film having a tantalum composition ratio of 50 to 97 atomic percent.

5. An electronic device according to claim 1, characterized in that said metal electrode is a tantalum film.

6. An electronic device according to claim 1, characterized in that said metal electrode is a molybdenum film.

7. An electronic device according to claim 1, characterized in that said molybdenum-tantalum alloy film constitutes the gate electrode of a thin-film transistor and said oxide film constitutes the gate insulating film of said thin-film transistor.

8. An electronic device according to claim 7, characterized in that said thin-film transistor has a semiconductor film of an amorphous silicon.

9. An electronic device according to claim 7, characterized in that said device has a multi-layered electrode having at least one said alloy containing layer.

10. An electronic device according to claim 1, characterized in that said molybdenum-tantalum alloy has a tantalum composition ratio of 50 to 84 atomic percent.

11. An electronic device according to claim 1, characterized in that said alloy contains more than 95 percent of molybdenum and tantalum as a total quantity.

12. A driving circuit substrate for display device comprising;
an insulating substrate (1);
a plurality of address lines (11) and data lines (13) intersecting each other on said substrate, said address line (11) being formed of a molybdenum-tantalum alloy having a tantalum composition ratio of 50 to 97 atomic percent;
a plurality of thin-film transistors (15) each formed at an intersection of said address and data lines (11, 13) and having a gate electrode (17) formed with a part of the address line (11) and a source electrode (18) connected to data line (13);
a plurality of display electrodes (21) being connected to a drain electrode (19) of the thin-film transistor (15); and
an oxide film (118) of said molybdenum-tantalum alloy being formed on at least one part of the address line.

13. A driving circuit substrate for display device according to claim 12, characterized in that said oxide film (118) is an anodic oxidized film.

14. A driving circuit substrate for display device according to claim 12, characterized in that said oxide film (118) is a thermally oxidized film.

15. A driving circuit substrate for display device according to claim 12, characterized in that said oxide film (118) is a gate insulating film being formed on the gate electrode (17).

16. A driving circuit substrate for display device according to claim 12, characterized in that said data line (13) is formed of a molybdenum-tantalum alloy having a tantalum composition ratio of 50 to 97 atomic percent.

17. A driving circuit substrate for display device according to claim 12, characterized in that said oxide film (118) is formed at an intersection of said address and data lines (11, 13).

18. A driving circuit substrate for display device according to claim 12, characterized in that semiconductor film of said thin-film transistor (15) is an amorphous silicon film.

19. A driving circuit substrate for display device according to claim 12, characterized in that said substrate (1) has multi-layered electrode having at least one said alloy containing layer.

20. A driving circuit substrate for display device according to claim 12, characterized in that said molybdenum-tantalum alloy has a tantalum composition ratio of 50 to 84 atomic percent.

21. A driving circuit substrate for display device according to claim 12, characterized in that said alloy contains more than 95 percent of molybdenum and tantalum as a total quantity.

F I G. 1

0273743

F I G. 2

F I G. 3

0273743

F I G. 4

0273743

F I G. 5

F I G. 6A

F I G. 6B

0273743

F I G. 7

F I G. 8

0273743

F I G. 9

F I G. 10